# EUROPÄISCHE PATENTSCHRIFT

(11) **EP 0 480 161 B1**
(45) Veröffentlichungstag und Bekanntmachung des Hinweises auf die Patenterteilung: **02.11.1995**
(21) Anmeldenummer: 91114509.2
(22) Anmeldetag: 29.08.1991
(51) Int. Cl.: G01R 35/00, G01D 5/24

(54) **Verfahren zum Kalibrieren einer Messeinrichtung**
Method for calibrating a measuring apparatus
Méthode pour calibrer un appareil de mesure

(30) Priorität: 06.10.1990 DE 4031754
(43) Veröffentlichungstag der Anmeldung: 15.04.1992
(73) Patentinhaber: ROBERT BOSCH GMBH, 70442 Stuttgart (DE)
(72) Erfinder: Paganon, Henry, F-69631 Venissieux (FR); Poulin, Philippe, F-69360 St. Symphorien d'Ozon (FR)

(56) Entgegenhaltungen:
- DE-A- 3 225 554

## Beschreibung

### Stand der Technik

Die Erfindung geht aus von einem Verfahren zum Kalibrieren einer Meßeinrichtung. Ein derartiges bekanntes Verfahren (z.B. DE-A-3 225 554) verwendet eine metallische Außenhülse, innerhalb derer sich parallel angeordnet einzelne Ringsegmente befinden, welche jeweils mit dem Außenteil einen Kondensator bilden. Beim Durchgang eines Strahls durch die Meßeinrichtung verändert sich die Dielektrizitätskonstante, je nach Abspaltung von Strahlteilen zwischen den einzelnen Kondensatorsegmenten. In einem geeigneten Meßgerät kann durch die genannte Veränderung ein Rückschluß auf die Strahlform gezogen werden. Dieses bekannte Verfahren hat sich als verbesserungsfähig erwiesen.

### Vorteile der Erfindung

Das erfindungsgemäße Verfahren mit den kennzeichnenden Merkmalen des Hauptanspruchs hat demgegenüber den Vorteil, daß die Meßgenauigkeit des Fluidstrahls verbessert wird und daß vor allem die Überprüfung und Eichung der Meßeinrichtung auf einfache Weise möglich ist.

Weitere Vorteile der Erfindung ergeben sich aus den Unteransprüchen.

### Zeichnung

Ein Ausführungsbeispiel der Erfindung ist in der nachfolgenden Beschreibung und Zeichnung näher erläutert. Letztere zeigt in Figur 1 eine perspektivische Ansicht der Meßeinrichtung, in Figur 2 einen Kalibrieraufsatz, ebenfalls in vereinfachter und perspektivischer Darstellung, in den Figuren 3a bis 3c alternativ ein Kalibriereinsatz, der den Abgleich eines einzelnen Segments erlaubt. Figur 4 zeigt die gesamte Strahlmeßeinrichtung in vereinfachter Darstellung.

### Beschreibung des Ausführungsbeispiels

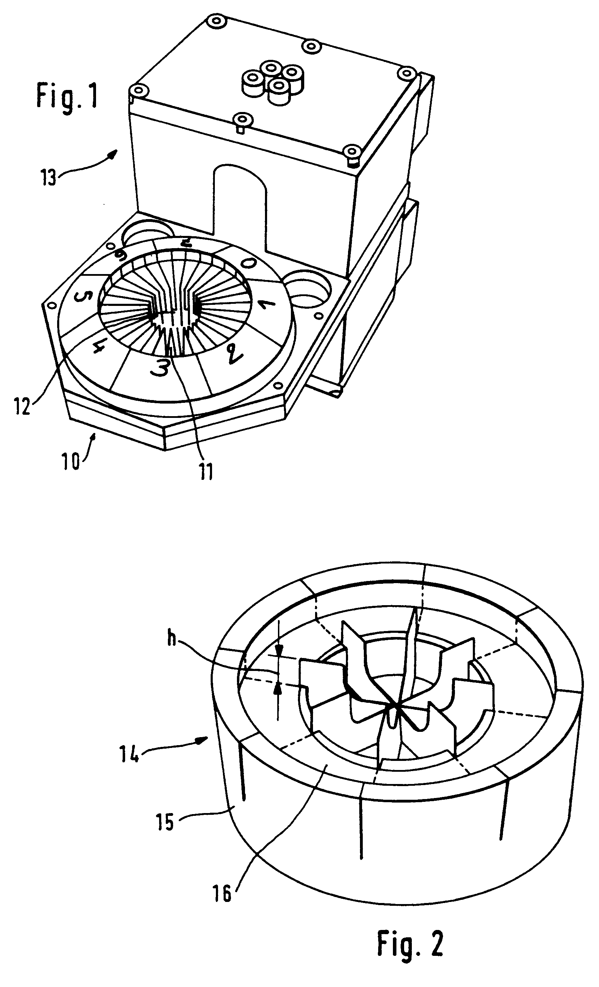

In Figur 1 ist die gesamte Meßeinrichtung dargestellt, die u. a. eine Meßscheibe 10 aufweist, die aus acht Segmenten (0 bis 7) besteht, wobei jedes Segment vier radial angeordnete Lamellen, die alle mit 11 bezeichnet sind, aufweist, und zwar derart, daß diese in ihrer Mitte einen Durchgang 12 freigeben. Die Lamellen stehen senkrecht und weisen - wie die Segmente - eine regelmäßige Teilung auf, d. h. ihre Winkelabstände sind exakt gleich. Die Lamellen bzw. Segmente 11 bilden Kondensatoren, deren Kapazität C bei angelegter Spannung u. a. wesentlich von der Dielektrizitätskonstanten des Dielektrikums zwischen den Lamellen abhängt, z. B. Luft; sie bestehen aus Kupfer.

Die Meßeinrichtung dient insbesondere zur Messung von Strahlen, die aus einer Einspritzdüse austreten. Der Strahl dringt durch die mittige Öffnung 12 hindurch. Ist er nicht genau konzentrisch oder diffus oder weist Seitenstrahlen auf, so dringen diese abgespaltenen Teile zwischen die Lamellen, wodurch sich jeweils die Dielektrizitätskonstante des betreffenden Kondensatorteils ändert. Im Test- und Auswertegerät 13 werden die Kapazitätsschwankungen registriert und aufgezeichnet. So ergibt sich ein genaues Bild über die Beschaffenheit des Strahls. Dieser kann optisch auf einem Bildschirm beobachtet oder aufgezeichnet werden. Die Vorrichtung ist insbesondere dafür gedacht, Drosselzapfendüsen mit Anschliff zur gewollten Erzeugung eines Seitenstrahls zu prüfen.

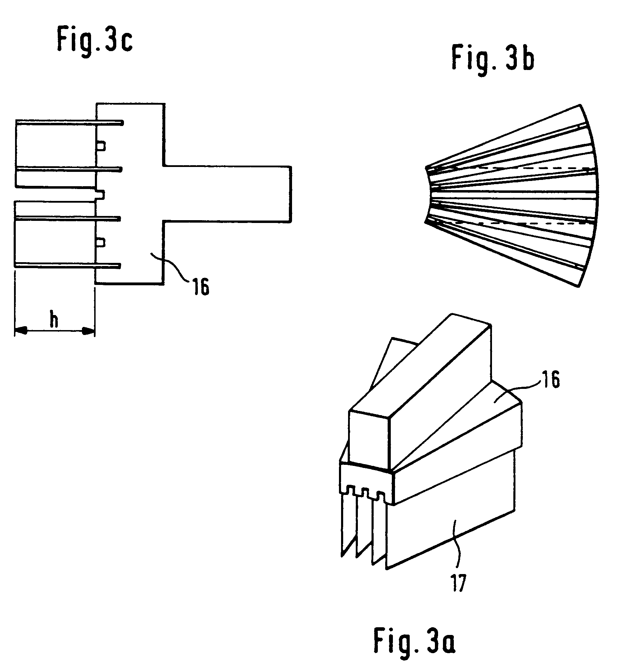

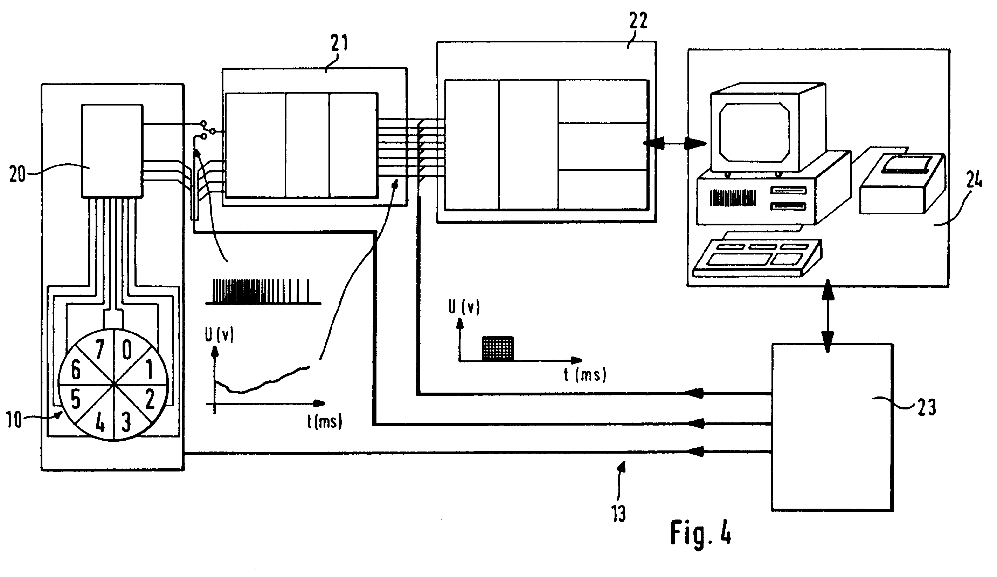

Wichtig ist, daß die oben beschriebene Meßeinrichtung kalibriert wird. Hierzu dienen Masken, wie sie in den Figuren 2 und 3a bis 3c dargestellt sind. Die Maske in Figur 2 besteht aus einem ringförmigen Außenkörper 15 mit acht Segmenten 16 aus Plexiglas. Da die Dielektrizitätskonstante der Meßeinrichtung zwischen den einzelnen Kondensatoren bzw. Segmenten nicht immer unbedingt konstant ist, wird die Maske 14 benutzt, um die Meßeinrichtung zu eichen. Sie wird derart in die Meßscheibe eingesteckt, daß an jeder Lamelle 11 eine Lamelle 17 anliegt. Sodann wird das Meßgerät aktiviert und die Eichung durchgeführt. Durch das Einführen der Plexiglaslamellen wird durch die Charakteristik dieses Werkstoffs in der Dielektrizitätskonstanten eine Kapazitätsveränderung hervorgerufen, die sich etwa in derselben Größenordnung bewegt, wie sie durch einen Strahl hervorgerufen wird. Die Abweichungen werden in einem Auswertegerät durch ein Verfahren, wie es in Figur 4 dargestellt ist, vollzogen. Pro Einsteckvorgang wird also jeweils ein Kondensator kalibriert. Dies reicht für die Überprüfung der Meßeinrichtung in der Regel aus. Für eine vollständige Kalibrierung während der Herstellung der Meßeinrichtung kann die Maske nach Figur 2 auch so oft verdreht eingesteckt werden, wie sie Lamellen besitzt (32mal).

Eine Alternative zur Maske nach Figur 2 zeigen die Figuren 3a bis 3c in verschiedenen Ansichten. Diese Kalibrierteile bestehen aus einzelnen Segmenten 16 mit Testlamellen 17. Hier werden sämtliche Lamellen eines Segments gleichzeitig geprüft (kalibriert). Das aufeinanderfolgende Einstecken von solchen Vorrichtungen in unterschiedlicher Tiefe (3c) erlaubt zusätzlich die Überprüfung des Antwortverhaltens der Kondensatoren in Abhängigkeit der Einstecktiefe. Dies gilt im übrigen auch für die Maske nach Figur 2.

Die Meßscheibe 10 ist an einen Oszillator 20 angeschlossen, der mit einem analog arbeitenden Auswertegerät 21 und einem nachgeschalteten Kapazitätsmeßgerät 22 in Wirkverbindung steht. Alle drei genannten Teile stehen ebenfalls mit einer elektronischen Auswerteeinrichtung 23 in Wirkverbindung, und diese mit einem Rechner und Darstellungsgerät 24. Auf diese Teile ist jedoch nicht weiter eingegangen, da sie nicht erfindungswesentlich sind.

## Patentansprüche

1. Verfahren zum Kalibrieren einer Meßeinrichtung für Fluidstrahlen, die eine aus verschiedenen Segmenten bestehende Meßscheibe (10) aufweist, wobei jedes Segment (0-7) eine größere Anzahl radial verlaufender Lamellen (11) aus metallischem Werkstoff in regelmäßiger Teilung hat, die an ihren Innenseiten einen kreisförmigen Durchlaß (12) für den Fluidstrahl freilassen, dadurch gekennzeichnet, daß zum Testen der Dielektrizitätskonstanten des Dielektrikums eine Testeinrichtung bestehend aus Testlamellen (17) aus einem nichtmetallischen Werkstoff, z. B. Plexiglas oder Keramik, dient, welche beim Kalibrieren der Meßscheibe zwischen die Lamellen (11) gesteckt wird, wodurch die Dielektrizitätskonstante in sehr ähnlicher Weise verändert wird, wie beim Durchgang eines Fluidstrahls, wobei die Meßergebnisse einer elektrisch-elektronischen Meßeinrichtung (13) signalisiert und dort gespeichert werden.

2. Einrichtung zur Durchführung des Verfahrens nach Anspruch 1, dadurch gekennzeichnet, daß die Testeinrichtung aus einer etwa topfförmigen Maske (14) besteht, in welcher die Testlamellen (17) angeordnet sind.

3. Einrichtung nach Anspruch 2, dadurch gekennzeichnet, daß die Testlamellen (17) in einzelnen Segmenten (16) angeordnet sind.

## Claims

1. Method for calibrating a measuring device for fluid jets, which has a measuring disc (10) consisting of various segments, each segment (0-7) having a relatively large number of radially extending lamellae (11), which are made from a metallic material, are regularly spaced and leave free at their inner sides a circular passage (12) for the fluid jet, characterized in that for the purpose of testing the dielectric constant of the dielectric use is made of a test device which consists of test lamellae (17) made from a nonmetallic material, for example plexiglas or ceramic, and is plugged between the lamellae (11) during calibration of the measuring disc, as a result of which the dielectric constant is varied in a very similar way as during the passage of a fluid jet, the measurement results being signalled to an electric/ electronic measuring device (13) and stored there.

2. Device for carrying out the method according to Claim 1, characterized in that the test device consists of a mask (14) which is approximately pot-shaped and in which the test lamellae (17) are arranged.

3. Device according to Claim 2, characterized in that the test lamellae (17) are arranged in individual segments (16).

## Revendications

1. Procédé pour calibrer un dispositif de mesure pour des veines fluides, qui présente un disque de mesure (10) formé de différents segments, dans le cas duquel chaque segment (0 à 7) a un assez grand nombre de lamelles (11) en une matière métallique selon une répartition régulière, lamelles qui ménagent sur leurs côtés intérieurs un passage de forme circulaire (12) pour la veine fluide, procédé caractérisé en ce que pour tester la constante diélectrique du diélectrique, on utilise un système de testage consistant en lamelles de testage (17) en un matériau non métallique, par exemple en Plexiglas ou en céramique, qui est foncé lors du calibrage du disque de mesure entre les lamelles (11), grâce à quoi la constante diélectrique se trouve modifiée d'une manière très analogue à celle résultant du passage d'une veine fluide, les résultats de la mesure étant fournis par des signaux, à un dispositif de mesure (13) électrique-électronique et mis en mémoire dans celui-ci.

2. Dispositif pour la mise en oeuvre du procédé selon la revendication 1, caractérisé en ce que le dispositif de testage consiste en un masque (14) ayant à peu près la forme d'un pot, dans lequel sont disposées les lamelles de testage (17).

3. Dispositif selon la revendication 2, caractérisé en ce que les lamelles de testage (17) sont disposées dans des segments individuels (16).
